# EUROPEAN PATENT APPLICATION

(11) **EP 3 176 673 A1**
(43) Date of publication of application: **07.06.2017**
(21) Application number: 15198011.7
(22) Date of filing: 04.12.2015
(51) Int. Cl.: G06F 1/26, G01R 31/36, G06F 1/28, G06F 11/30, H02J 7/00

(54) **POWER CONSUMPTION MEASUREMENT ARRANGEMENT AND METHOD**

(71) Applicant: Basemark Oy, 00130 Helsinki (FI)
(72) Inventor: VIROLAINEN, Teemu, 02130 Espoo (FI); ROMPPAINEN, Mikko, 00180 Helsinki (FI)
(74) Representative: Seppo Laine Oy

(57) **Abstract**

The invention relates to an arrangement and a method for determining power consumption of battery powered mobile devices. According to the invention, a battery operated devices running at least one specific software application. A power measuring device is connected to a battery charging port of the battery operated device and to a computer for measuring electrical power consumed by the battery operated device over a predefined period of time. The power measuring device is communicating power consumption information to the computer, which is adapted to run a software capable of measuring the power consumed by said at least one specific software application, by deducting an idle mode power consumption from the total power drawn by the battery operated device.

## Description

### Field of the Invention

The present invention relates to an arrangement and a method for determining power consumption of battery powered mobile devices. More particularly, the invention offers a novel way of measuring and comparing performance per watt of a mobile or embedded device.

### Background of the Invention

Raw performance in terms of clock frequencies and other hardware-specific features is usually quoted when comparing mobile processors and graphics processing units. Such figures and details do however not reveal anything about power consumption of the unit, and are as such not enough to allow a device manufacturer to pick the most cost-effective or economical chips for a device. On the other hand, efforts to optimize code in order to minimize the power consumption, like the one presented in US2013/0073883, are confined to prototype testing of SW modules on usually specific platforms, and have little significance outside laboratories in a wealth of independent applications and consumer devices.

Many solutions exist for measuring the power consumption of a mobile device. Most devices have an in-built "fuel gauge" (FG), which provides accurate readings of battery voltage and instantaneous current draw for displaying remaining battery life.

Power modelling is one approach to the problem of on-board energy profiling of a device. Modeling strives to accurately attribute the energy consumed by particular applications and methods, which can both produce power readings and attribute them to code entities. However, tail power states complicate energy profiling. To provide responsiveness, many components (e.g., radio, GPS) continue to draw high power after use. A 3G radio may remain in a higher "tail" power state for up to seven seconds after use. This tail power state, combined with the fact that several applications may have used the same component, complicates energy attribution: the download has completed, the code has moved on, and the application(s) may no longer be running, but power is still drawn. A further issue is that a majority of the device manufacturers do not report power consumption data, which makes an independent software-based modeling solution difficult to design.

A hybrid approach involving modelling combined with accurate battery sensors to gather online power readings and system call modelling to handle components with tail states is presented in the article of James Bornholt, Todd Mytkowicz, and Kathryn S. McKinley. "The model is not enough: understanding energy consumption in mobile devices." Power (watts) 1.2 (2012): 3

It can thus be established that known solutions work only on single platforms during specific conditions. There is no standardized way of measuring power consumption where a true comparison or benchmarking may be done across devices and platforms. There are also no set of standard performance benchmarks to compare performance in conjunction of the power consumption. In addition, prior art does not tackle the problem of determining power usage when the device can drain power from battery while simultaneously being attached to a power source. It is accordingly an object of the present invention to remarkably improve the situation, by the inventive arrangement and method which allows for measurement of performance and power consumption on practically any consumer device. There is no need for expensive jigs or custom power sources. The inventive concept works on any device that can be charged via a standard interface, such as a USB port. The inventive solution does not depend on the exact port connectors, voltage or current levels used. The inventive solution enables direct comparison between different devices, as the measurement methodology remains the same and yields comparable results across device platforms. It thus provides a possibility of independent power consumption measurements where previous solutions cannot be used.

### Summary of the Invention

The invention offers significant advantages and opens new possibilities for benchmarking. By using the inventive methodology in conjunction with a cross-platform benchmarking software, the performance per watt of a device running a specific application can be compared across practically all relevant mobile platforms. Moreover, the inventive arrangement and method also allow software developers to measure and optimize the power consumption of their own software across multiple devices. This currently is generally out of reach for most SW developers for mobile devices.

The inventive arrangement provides for determining power consumption in re-chargeable battery operated devices that may run one or more specific software applications. These software applications are chosen for various reasons, including importance, popularity or high energy demand. The software may also be a prototype which energy consumption needs to be profiled on one or a multitude of mobile computing platforms. The arrangement includes a power measuring device connected on one hand to a battery charging port of the battery operated device, and on the other hand to a computer, typically a PC or other general purpose computer, for measuring electrical power consumed by the battery operated device. The measurement is performed over a predefined period of time. The power measuring device is communicating obtained power consumption information to the computer which is adapted to run a software capable of measuring the power consumed by the specific software application(s), by deducting an idle mode power consumption from the total power drawn by the battery operated device.

Furthermore, the power measuring device is preferably also adapted to interconnect an external charging device to the battery of the battery operated device. In this way the measuring device can measure any power drawn from said charging device and add it to any battery power consumption information sent to the computer, thus obtaining a total consumption value.

The measuring device may comprise connectors for receiving voltage and current information from said battery operated device, a microcontroller and at least two analog-to-digital converters and a computer USB interface unit operated by said microcontroller. The input ports will transfer to the microcontroller voltage information from across the poles of the battery and current flow information into the battery operated device. The analog-to-digital converters convert the measured voltage and current signals into digital information, and the USB interface unit acts as communication means for communicating the digital information to the computer to be read by the measurement software.

The software is preferably adapted to store in a table-like data structure the measured power consumption of any number of devices, in the context of the specific applications that have been ran on them. In this way, the results are easy to compare and present, in order to indicate any differences in power consumption between the devices while running the specific software applications in question.

The predefined period of time may include a period of time for determining the idle mode power consumption of the battery operated device in question. This can be done before or after the running time of the specific software application, or both before and after. The idle mode power consumption can be measured when the battery in said battery operated device has been fully charged, the device has been put in idle mode and the power consumption has dropped to a stable value, i.e. to a baseline power usage level. In this way, devices with variable charging profiles can be accommodated, as some devices may initially draw maximum power and then instantly stop charging, while others have an exponentially decaying power drain curve.

The present invention also relates to a method for determining power consumption in battery operated devices, including the steps of:
- running at least one specific software application in the battery operated device;
- measuring with a measuring device the power consumed by the battery operated device over a predefined period of time;
- communicating the measured power consumption information from the measuring device to a computer;
- running on the computer a software capable of measuring the power consumed by said at least one specific software application, by deducting an idle mode power consumption from the total power drawn by the battery operated device.

According to the inventive method, wherein measured power consumption of a multitude of battery operated devices may be stored, compared and presented on the computer, the comparison of the power consumption of the devices may also be made against a predetermined benchmark value stored in the computer and used by the software running there. This would enable one to create a standardized power consumption measuring methodologies for any computing platforms and/or applications of interest to be compared.

The inventive method may further comprise measuring said idle mode power consumption when a battery in said battery operated device has been fully charged, the battery operated device has been put in idle mode and power consumption has dropped to a stable value.

The inventive method may further comprise running the at least one specific software application in said battery operated device.

### Brief Description of the Drawings

The invention is described in more detail in the following by referring to the drawings, where
Fig. 1 shows an overview of the inventive arrangement;
Fig. 2 shows a block diagram of an measuring device used in the invention.

### Detailed Description

In some embodiments, external measurement hardware is used to measure power drawn from a phone's battery. Such tools are expensive, and limit the phone mobility, restricting real world testing. They tend to be limited to laboratory environments and are used by phone manufacturers to fine-tune their own hardware. Prior art solutions that works only on in specifically designed and/or modified devices are presented in US6907278 B2 and US2008/0315844.

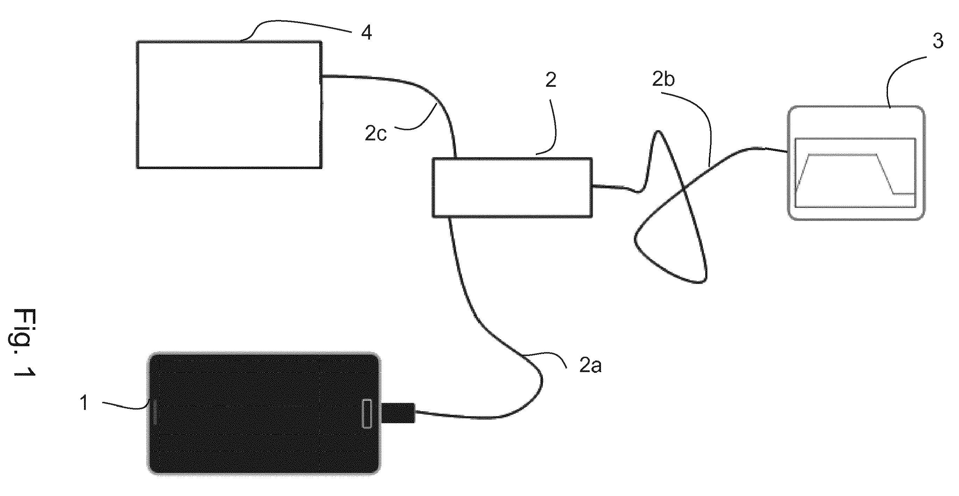

In Fig. 1 is shown an example of an inventive arrangement, comprising a battery operated device 1, a power measuring device 2, a computer 3 and a charging device 4. The measuring device2 is connected to all other devices by cables 2a, 2b and 2c, respectively. At least the connection 2b may also be a wireless connection instead of a typical USB cable. Also cable 2c and partly cable 2a partly may without departing from the invention at be replaced by e.g. wireless inductive charging arrangements. The software running on the computer 3 will preferably read the data sent by the measuring device 2 automatically as the test is underway.

The device 1 is connected to the power measuring device 2. The idle power consumption of device 1 is determined by measuring the power drain while the device is fully charged. During a measurement cycle, the application software under testing is ran in device 1 until the device either starts to charge its battery, or it is determined that the device can run the intended application at the intended speed without draining extra power from the battery. In this way, a ramp-up phase of the device is bypassed and the energy consumption associated with that is not affecting the results. The total energy consumed by the software under inspection is calculated by the total energy during the benchmark run + total energy charged. From this total power consumption the consumed wattage can be calculated, as the time period the software was operational is known. To make the results between devices comparable, the idle mode power consumption of the device is deducted from the total power drawn by the device. This can be done by tracking the time the software is running and calculating the energy consumed by device 1 by multiplying the total power consumption with that time (energy (Joule) = power (W) * time). The net energy charged to the device 1 from charger 4 may be determined by subtracting from the total charged energy the idle mode or baseline power consumption during the whole charging period.

The software for calculating the power consumption is thus running the computer 3, and it communicates with the measuring device 2 via a USB cable 2b. The software reads the voltage and the current values sent by the measuring device 2, and calculates the power consumption, and shows it to the user of the computer 3. Obviously the measurement software can be available in various versions, depending on the use. For example, a simple version may do only the total wattage calculation, an advanced version may show more detailed information, such as the timeline of power consumption.

At the end of the test a result may be displayed on the computer 3 to the user either as total energy consumption or as an average wattage. According to the invention, this can be done even if part of the power is being supplied by the battery charger. The device is fully charged when the power consumption has dropped close to the baseline power usage. Then, the idle mode power consumption can be measured. Thus devices with variable charging profiles can be accommodated, as some devices draw max power and then instantly stop charging, and others have an exponentially decreasing power drain curve.

Comparative device studies on their performance per watt can be easily be performed with benchmarks used as input to the software running on the computer 3.

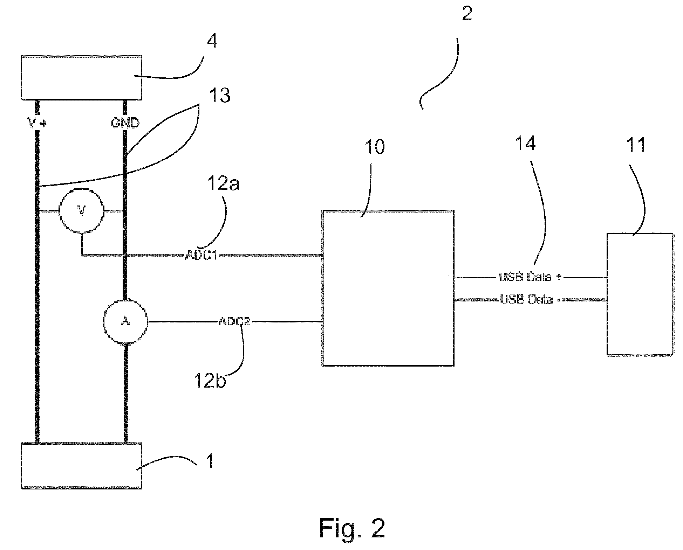

Referring now to Fig. 2, it shows the power measuring device 2 of the present invention, which measures current and voltage readings of the device (1). The measuring device 2 consists of circuitry for measuring voltage (V) and current (A) values from device power/charging wire 13. The device comprises a microcontroller 10 and analog-to-digital converters 12a, 12b to transforming the measured power values into digital format. The digital information 14 is then transferred to the computer e.g. via an USB interface or client 11.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of components, connections, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

## Claims

1. An arrangement for determining power consumption in battery operated devices running at least one specific software application, said arrangement comprising a power measuring device connectable to a battery charging port of said battery operated device and to a computer for measuring electrical power consumed by said battery operated device over a predefined period of time, wherein the power measuring device is configured to communicate power consumption information to said computer which is adapted to run a software capable of measuring the power consumed by said at least one specific software application by deducting an idle mode power consumption from a total power drawn by said battery operated device.

2. The arrangement for determining power consumption according to claim 1, wherein the power measuring device is configured to interconnect a charging device to the battery of said battery operated device, said measuring device being adapted to measure any power drawn from said charging device and adding that to the power consumption information sent to said computer.

3. The arrangement according to claim 1, wherein the measuring device further comprises input ports configured to receive voltage information from across poles of a battery in said battery operated device and current flow information into said battery operated device, as well as further comprising an analog-to-digital converter configured to convert measured voltage and/or current signals into digital information, and wherein the measuring device is configured to communicate said digital information to be read by said software running in said computer.

4. The arrangement according to claim 1, wherein the power measuring device is configured to communicate power consumption information to said computer over a universal serial bus (USB) port.

5. The arrangement according to claim 1, wherein the arrangement comprises the computer and wherein said software running in said computer is adapted to store measured power consumption of at least two battery operated devices each running said at least one specific software application, and to compare and present the results in order to indicate differences in power consumption between the battery operated devices when they run said at least one specific software application.

6. The arrangement according to claim 1, wherein the measurement of electrical power consumed by said battery operated device over said predefined period of time includes a period of time for determining said idle mode power consumption before and/or after a running time of said at least one specific software application.

7. The arrangement according to claim 1, wherein the power measuring device is configured to measure said idle mode power consumption when a battery in said battery operated device has been fully charged, the device has been put in idle mode and the power consumption has dropped to a stable value.

8. The arrangement according to claim 1, wherein said power measuring device comprises connectors for receiving voltage and current information from said battery operated device, a microcontroller, at least two analog-to-digital converters and a computer USB interface unit operated by said microcontroller.

9. A method for determining power consumption in a battery operated device, comprising:
- measuring with a measuring device the power consumed by said battery operated device while running at least one specific software application over a predefined period of time;
- communicating the measured power consumption information from said measuring device to a computer, and
- running on said computer a software capable of measuring the power consumed by said at least one specific software application, by deducting an idle mode power consumption from a total power drawn by said battery operated device.

10. The method for determining power consumption according to claim 9, further comprising measuring any power drawn from a charging device connected to a battery of said battery operated device, and adding any measured additional power consumption information to the measured power consumption information communicated to said computer.

11. The method for determining power consumption according to claim 9, wherein the measuring of power consumption of said battery operated device by the measuring device further comprises:
- receiving voltage information from across poles of a battery of said battery operated device;
- receiving current flow information into said battery operated device;
- converting measured voltage and current signals into digital information by a analog-to-digital conversion means;
- communicating said digital information to be read by said software running in said computer.

12. The method according to claim 9, wherein measured power consumption of at least two battery operated devices running said at least one specific software application are stored, compared and presented, indicating the differences in power consumption between the battery operated devices when they run said at least one specific software application.

13. The method according to claim 12, wherein the comparison of battery operated devices is made against a predetermined benchmark value of power consumption for said at least one specific software application.

14. The method according to claim 9, further comprising measuring electrical power consumed by said battery operated device over said predefined period of time that includes a period of time for determining said idle mode power consumption before and/or after a running time of said at least one specific software application.

15. A non-transitory computer readable medium having stored thereon a set of computer readable instructions for:
- receiving voltage information from across poles of a battery of said battery operated device;
- receiving current flow information into said battery operated device;
- converting measured voltage and current signals into digital information by an analog-to-digital conversion means, and
- communicating said digital information to be read by software running in a computer.
